# EUROPEAN PATENT SPECIFICATION

(11) **EP 4 173 025 B1**
(45) Date of publication and mention of the grant of the patent: **26.11.2025**
(21) Application number: 21737400.8
(22) Date of filing: 25.06.2021
(51) Int. Cl.: H01L 21/673

(54) **WAFER BOATS FOR SUPPORTING SEMICONDUCTOR WAFERS IN A FURNACE**
WAFERHORDE ZUM TRAGEN VON HALBLEITERWAFERN IN EINEM OFEN
SUPPORTS DE TRANCHES POUR SUPPORTER DES TRANCHES DE SEMI-CONDUCTEUR DANS UN FOUR

(30) Priority: 26.06.2020 US 202063044698 P
(43) Date of publication of application: 03.05.2023
(73) Proprietor: GlobalWafers Co., Ltd., Hsinchu (TW)
(72) Inventor: HOLM, Hans, 84367 Tann (DE); HOLM, Florian, 84367 Tann (DE)
(74) Representative: Maiwald GmbH
(86) International application number: PCT/EP2021/067523
(87) International publication number: WO 2021/260189

(56) References cited:
- EP-A1- 0 884 769
- US-A- 5 779 797
- US-A1- 2005 205 502
- US-B1- 10 008 402

## Description

### FIELD OF THE INVENTION

The field of the invention relates to semiconductor wafer boats for supporting semiconductor wafers and, more particularly, semiconductor wafer boats for use in the heat-treatment of semiconductor wafers in a furnace.

### BACKGROUND

Semiconductors wafers are commonly heat-treated at high temperatures (i.e., annealed) to achieve certain desirable characteristics. For example, annealing may be used to create a defect free layer of silicon on the wafer. The high temperature annealing process is typically carried out in a vertical furnace which subjects the wafers to temperatures above 1100°C (e.g., between about 1200°C and about 1300°C).

A plurality of semiconductor wafers may be supported in the vertical furnace by a wafer boat or "rack". The wafer boat includes one or more supports on which the semiconductor wafer rests. During exposure to the high temperatures, particularly temperatures above 1100°C, the wafers become temporarily more plastic, i.e., the yield strength of the wafers decreases. Contact areas on the wafer where the wafer is supported may undergo slip due to local gravitational and thermal stresses. Slip may introduce contaminants into the wafer. In addition, excessive slip may lead to plastic deformation of the wafers, leading to production problems, such as photolithography overlay failures causing yield losses in device manufacture.

The supports aim to hold the semiconductor wafer while minimizing local gravitational and thermal stresses to prevent slip and plastic deformation while the wafers are being heat-treated. Conventionally, a wafer boat used in a vertical furnace includes three or more rods. The rods have laterally extending fingers lying generally in a common horizontal plane. This configuration is conventional and generally adequate for heating wafers with smaller diameters such as 200 mm or less. Larger diameter wafers (e.g., greater than 200 mm) are subjected to greater local gravitational and thermal stress than smaller diameters wafers. Such larger diameter wafers are conventionally loaded onto support rings which provide a greater surface area for supporting the wafers. The support rings increase the time for loading and unloading of the semiconductor wafers onto the wafer boat.

A need exists for wafer boats that include supporting structures that reduce local gravitational and thermal stress in order to limit the incident of slip while supporting semiconductor wafers as they are subjected to high temperatures during an annealing process and for wafer boats that are capable of relatively high throughput for loading and unloading wafers.

US 10,008,402 B1 describes vertical wafer boats with three support posts. US 5,779,797 A describes a wafer boat including a plurality of support posts and a plurality of supporting bars, each of which extends laterally from each of the support posts.

### SUMMARY

The present invention is directed to a wafer boat for supporting a plurality of semiconductor wafers in a furnace. The wafer boat includes a first vertical rod and a first set of fingers that extend radially inward from the first vertical rod along a first finger axis. The first finger axis extends over a chord of a circle centered about a longitudinal central axis of the wafer boat, the chord not intersecting the longitudinal central axis of the wafer boat. Each finger of the first set includes an elongated segment that extends from the first vertical rod and a contact protuberance disposed on the elongated segment toward a distal end of the finger for contacting and supporting a semiconductor wafer. At least a portion of the contact protuberance is raised with respect to the elongated segment. The wafer boat moreover comprises a second vertical rod and a second set of fingers that extend radially inward from the second vertical rod along a second finger axis. The second finger axis extends over a chord of the circle, the chord not intersecting the longitudinal central axis of the wafer boat. Each finger of the second set comprises an elongated segment that extends from the second vertical rod and a contact protuberance disposed on the elongated segment toward a distal end of the finger for contacting and supporting a semiconductor wafer, at least a portion of the contact protuberance being raised with respect to the elongated segment. The wafer boat moreover comprises a third vertical rod and a third set of fingers that extend radially inward from the third vertical rod along a third finger axis, the third finger axis extending over a chord of the circle, the chord intersecting the longitudinal central axis of the wafer boat. Each finger of the third set comprises an elongated segment that extends from the third vertical rod and a contact protuberance disposed on the elongated segment toward a distal end of the finger for contacting and supporting a semiconductor wafer, at least a portion of the contact protuberance being raised with respect to the elongated segment.

The contact protuberances of the first, second, and third sets of fingers are spaced 120° about the wafer boat. Each contact protuberance is rounded by increasing in height from sides of the contact protuberance to an apex that extends along the finger axis. Each contact protuberance has a longitudinal contact protuberance axis, a length extending along the longitudinal contact protuberance axis, and a width perpendicular to the length, the width of each contact protuberance being 3 mm to 20 mm, the length of each contact protuberance being 10 mm to 50 mm, and the distance from the contact protuberance to a longitudinal central axis of the wafer boat being from 75 mm to 125 mm, for resting the semiconductor wafer on the rounded contact protuberance generally along the longitudinal contact protuberance axis

Various refinements exist of the features noted in relation to the above-mentioned present invention. Further features may also be incorporated in the above-mentioned present invention as well. These refinements and additional features may exist individually or in any combination. For instance, various features discussed below in relation to any of the illustrated embodiments of the present invention may be incorporated into the present invention, alone or in any combination.

### BRIEF DESCRIPTION OF THE DRAWINGS

Fig. 1 is a perspective view of a wafer boat;
Fig. 2 is a top view of the wafer boat showing contact protuberances;
Fig. 3 is a detailed view of a contact protuberance shown in Fig. 2;
Fig. 4 is a detailed view of a contact protuberance that is not according the claimed invention; and
Fig. 5 is a probability plot of the slip length for a first and second length of a contact protuberance.

Corresponding reference characters indicate corresponding parts throughout the drawings.

### DETAILED DESCRIPTION

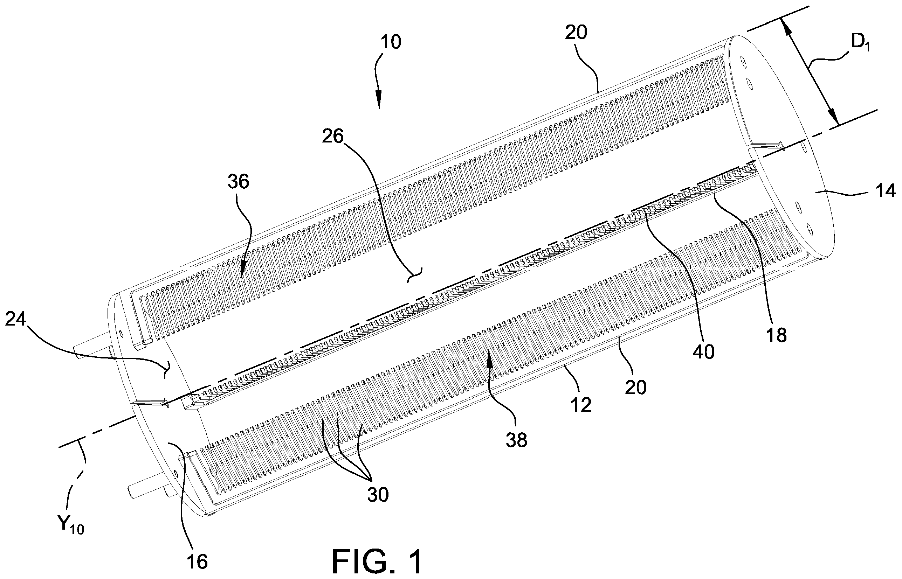

An example wafer boat for supporting a plurality of semiconductor wafers in a vertical furnace is indicated generally at "10" in Fig. 1. The wafer boat 10 supports the plurality of semiconductor wafers during a high temperature heat-treatment process (also referred to herein as an "anneal"). The wafer boat 10 includes three or more vertical rods 12 that are coupled to a top 14 and a base 16 of the wafer boat 10. The wafer boat 10 includes a longitudinal central axis Y₁₀ which extends from the top 14 to the base 16. The vertical rods 12 are arranged a distance D₁ from the longitudinal central axis Y₁₀ (Fig. 1).

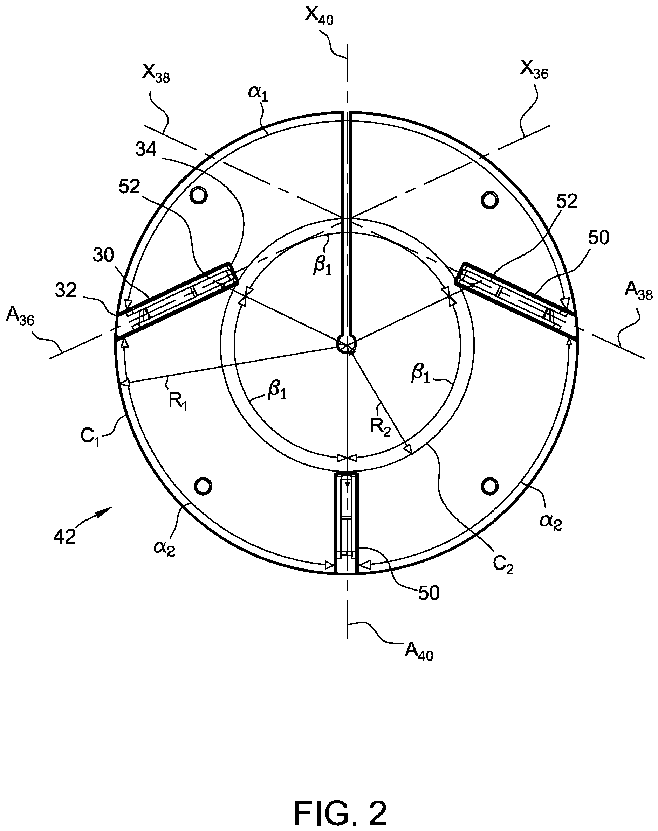

The illustrated wafer boat 10 includes three vertical rods 12 and, in particular, a central rod 18 and two forward rods 20. Each of the vertical rods 12 is arranged on a first circle C₁ (Fig. 2) centered about the longitudinal central axis Y₁₀ and having a radius R₁. The two forward rods 20 are spaced apart about the longitudinal central axis Y₁₀ by a first angle α₁. The central rod 18 is spaced an equal circumferential distance between the two forward rods 20, such that the central rod 18 is spaced about the longitudinal central axis Y₁₀ at a second angle α₂ relative to each of the two forward rods 20. The two forward rods 20 are spaced apart by the first angle α₁ such that an entrance 24 (Fig. 1) is defined between the two forward rods 20. The first angle α₁ may be any suitable angle such that the entrance 24 is sized to allow a semiconductor wafer to pass through the entrance 24 and arranged within an interior space 26 of the wafer boat 10. For example, the first angle α₁ may be 180° or more and the second angle α₂ may be 90° or less.

The wafer boat 10 includes fingers 30 that extend radially inward from the vertical rods 12 for supporting semiconductor wafers (i.e., the boat does not include support rings for supporting wafers). The two forward vertical rods 20 include a first and a second set 36, 38 of fingers 30, respectively. The central vertical rod 18 includes a third set 40 of the fingers 30. The first set 36 of fingers 30 extend along a first finger axis A₃₆, the second set 38 of fingers 30 extend along a second finger axis A₃₈, and the third set 40 of fingers extends along a third finger axis A₄₀. Each finger axis A₃₆, A₃₈, A₄₀ extends from a proximal end 32 of the finger 30 to a distal end 34 of the finger 30. The proximal end 32 of the finger 30 is proximate to the vertical rods 12 and the distal end 34 of the finger 30 is disposed in the interior space 26 of the wafer boat 10. The fingers 30 may be formed integrally with the vertical rods 12, e.g., cuts may be made in an elongate one-piece structure to form the fingers 30. Alternatively, the fingers 30 may be formed separately and coupled to the vertical rods 12.

The finger axes A₃₆, A₃₈ of the first and second sets 36, 38 of fingers 30, each extends over a chord X₃₆, X₃₈ of the first circle C₁. The chords X₃₆, X₃₈ do not intersect the longitudinal central axis Y₁₀ of the wafer boat 10 (i.e., the first and second sets 36, 38 of fingers are not centered such that they point to the longitudinal central axis Y₁₀). The finger axis A₄₀ of the third set 40 of fingers 30 extends over a chord X₄₀ of the first circle C₁ that intersects the longitudinal central axis Y₁₀.

A group 42 of fingers 30 that extend from each of the vertical rods 12 lies in the same, generally horizontal, plane to enable the group 42 of fingers 30 to support a semiconductor wafer. The distal ends 34 of the fingers 30 in the group 42 lie on a second circle C₂. The second circle C₂ has a radius R₂ and is centered on the longitudinal central axis Y₁₀. The radius R₂ extends from the distal ends 34 of the fingers 30 to the longitudinal central axis Y₁₀ of the wafer boat 10. In the illustrated embodiment, each of the distal ends 34 of the fingers 30 in the group 42 is arranged at an equal circumferential distance from each of the other distal ends 34 of the other fingers 30 in the group 42. For example, in the illustrated embodiment including the first, second, and third sets 36, 38, 40 of fingers 30, the distal ends 34 of each of the first, second, and third sets 36, 38, and 40 of fingers 30 are each spaced apart by an angle β defined on the second circle C₂ centered on the longitudinal central axis Y₁₀. In the illustrated embodiment, the angle β is 120°.

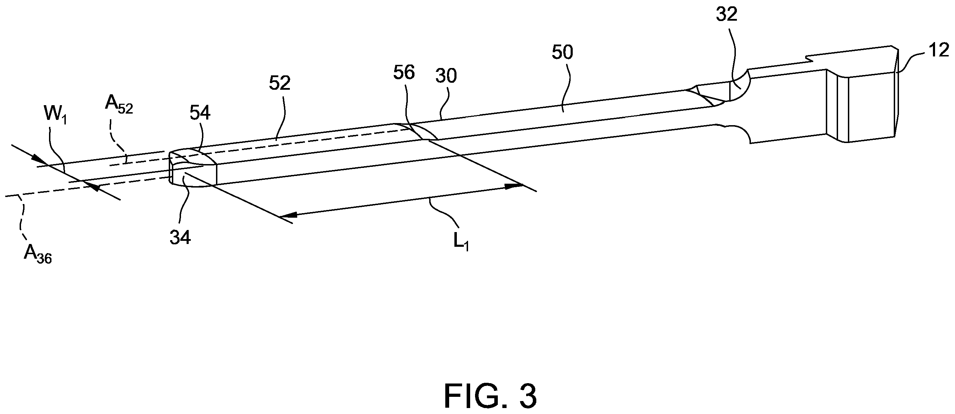

With reference to Fig. 3, each of the fingers 30 includes an elongated segment 50 that extends from the vertical rod 12 and a contact protuberance 52 disposed on the elongated segment 50 towards the distal end 34 of the finger 30. The contact protuberance 52 contacts and supports a semiconductor wafer. The contact protuberance 52 is raised with respect to the elongated segment 50. The contact protuberance 52 has a first end 54, a second end 56, and a longitudinal contact protuberance axis A₅₂ that extends through the first and second ends 54, 56 of the contact protuberance 52. The contact protuberances 52 may be used to support any diameter of wafer including 200 mm diameter wafers, 300 mm diameter wafers and/or wafer that are greater than 300 mm in diameter.

The illustrated contact protuberances 52 are rounded by increasing in height from each side to an apex that extends along the axis A₃₆. The rounded contact protuberance 52 includes a surface that is generally cylindrical in shape. Each contact protuberance 52 includes a length L₁ extending along the longitudinal contact protuberance axis A₅₂ and a width W₁ perpendicular to the length L₁. The wafer rests on the rounded contact protuberance 52 generally along the longitudinal contact protuberance axis A₅₂.

Each contact protuberance 52 has a width W₁ of 3 mm to 20 mm, a length L₁ of 10 mm to 50 mm, and the distance from the contact protuberance 52 to a longitudinal central axis Y₁₀ of the wafer boat is from 75 mm to 125 mm. In some embodiments, the contact protuberance 52 has a width W₁ of 8 mm, a length L₁ of 30 mm, and the distance from the contact protuberance 52 to a longitudinal central axis Y₁₀ of the wafer boat 10 is 100 mm.

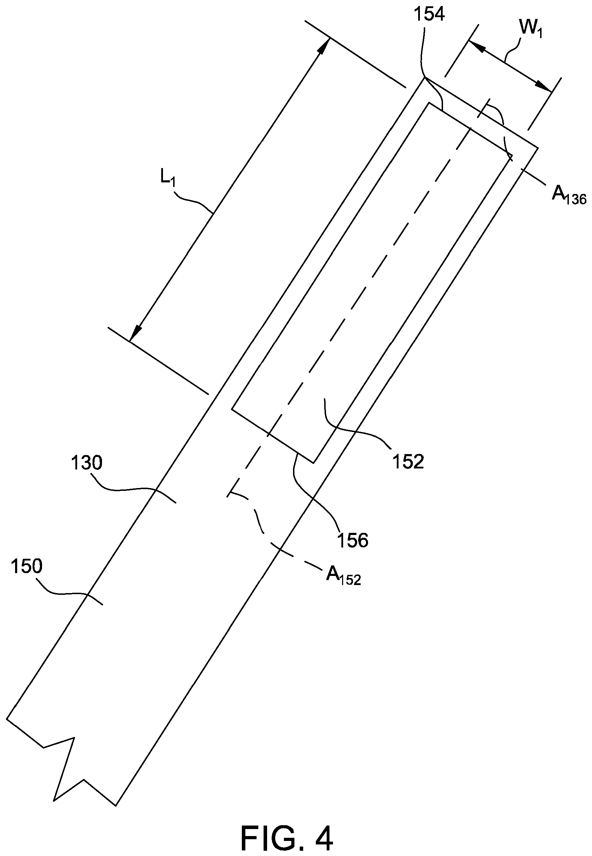

In Fig. 4, the contact protuberance 52 is flat, which is not according to the claimed invention. The components shown in Fig. 4 that are analogous to those of Figs. 1-3 are designated by the corresponding reference number of Figs. 1-3 plus "100" (e.g., part 52 becomes 152). The flat contact protuberance 152 includes a contact surface having a surface area that is defined by the length L₁ extending along the longitudinal contact protuberance axis A₁₅₂ and the width W₁, perpendicular to the length L₂. The surface, in its entirety, is generally in contact with the semiconductor wafer resting on the flat contact protuberance 152.

The contact protuberance 152 may have a width W₁ of 3 mm to 20 mm, a length L₁ of 10 mm to 50 mm, and the distance from the contact protuberance 152 to a longitudinal central axis Y₁₀ of the wafer boat 10 may be from 75 mm to 125 mm. Alternatively or in addition, the contact protuberance 152 may have a width W₁ of 8 mm, a length L₁ of 25 mm, and the distance from the contact protuberance 152 to a longitudinal central axis Y₁₁₀ of the wafer boat may be 100 mm. The wafer rests on the flat contact protuberance 152 such that the wafer is in contact with the entirety of the surface area.

The wafer boats of the present invention have several advantages compared to conventional wafer boats. Contact protuberances reduce the contact area between the wafer boat and the wafer which reduces slip. Equally circumferentially spaced contact protuberances promote even distribution of the wafer weight onto each of the contact protuberances. As known to one skilled in the art, the peak stress in the wafer is sensitive to machining inaccuracies of the contact protuberances which can cause uneven loading. Dimensions and shape of the rounded contact protuberances minimize the effect of potential machining inaccuracies to limit uneven loading the of the wafer weight.

### EXAMPLES

The present invention is further illustrated by the following Example. This Example should not be viewed in a limiting sense.

### Example 1: Probability Plot of Slip Length

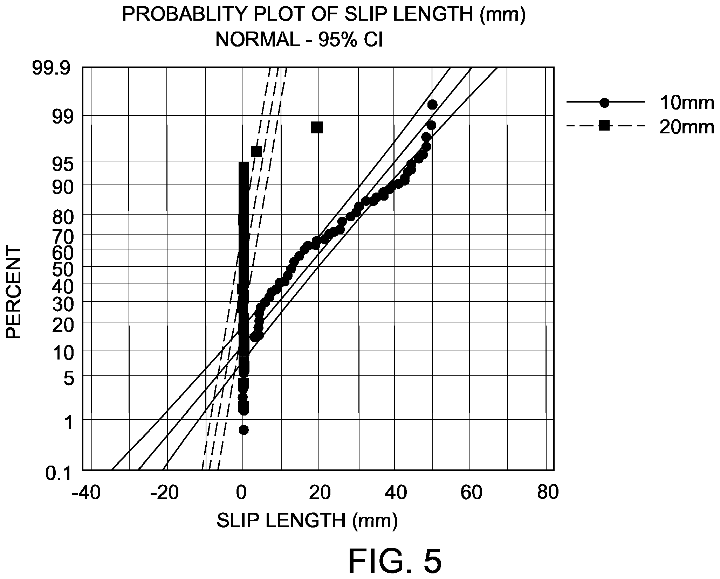

Sets of silicon wafers were annealed using wafer boats including rounded contact protuberances having a length of 10 mm and another set was annealed in wafer boat including rounded contact protuberances having a length of 20 mm. Probability slip length, at a confidence interval of 95%, was determined for wafer boats having cylindrical contact protuberances for each of the contact protuberance lengths of 10 mm and 20 mm (Fig. 5). As shown in Fig. 5, the 20 mm length contact protuberance resulted in a reduced slip length relative to the 10 mm contact protuberance.

As used herein, the terms "about," "substantially," "essentially" and "approximately" when used in conjunction with ranges of dimensions, concentrations, temperatures or other physical or chemical properties or characteristics are meant to cover variations that may exist in the upper and/or lower limits of the ranges of the properties or characteristics, including, for example, variations resulting from rounding, measurement methodology or other statistical variation.

When introducing elements of the present invention or the embodiment(s) thereof, the articles "a," "an," "the," and "said" are intended to mean that there are one or more of the elements. The terms "comprising," "including," "containing," and "having" are intended to be inclusive and mean that there may be additional elements other than the listed elements. The use of terms indicating a particular orientation (e.g., "top," "bottom," "side," etc.) is for convenience of description and does not require any particular orientation of the item described.

## Claims

1. A wafer boat (10) for supporting a plurality of semiconductor wafers in a furnace comprising:
a first vertical rod (20);
a first set (36) of fingers (30) that extend radially inward from the first vertical rod along a first finger axis A₃₆, the first finger axis extending over a chord X₃₆ of a circle centered about a longitudinal central axis Y₁₀ of the wafer boat, the chord not intersecting the longitudinal central axis Y₁₀ of the wafer boat, each finger of the first set comprising:
an elongated segment (50) that extends from the first vertical rod; and
a contact protuberance (52) disposed on the elongated segment toward a distal end (34) of the finger (30) for contacting and supporting a semiconductor wafer, at least a portion of the contact protuberance being raised with respect to the elongated segment;
a second vertical rod (20);
a second set (38) of fingers (30) that extend radially inward from the second vertical rod along a second finger axis A₃₈, the second finger axis extending over a chord X₃₈ of the circle, the chord not intersecting the longitudinal central axis Y₁₀ of the wafer boat, each finger of the second set comprising:
an elongated segment (50) that extends from the second vertical rod; and
a contact protuberance (52) disposed on the elongated segment toward a distal end (34) of the finger (30) for contacting and supporting a semiconductor wafer, at least a portion of the contact protuberance being raised with respect to the elongated segment;
a third vertical rod (18);
a third set (40) of fingers (30) that extend radially inward from the third vertical rod along a third finger axis A₄₀, the third finger axis extending over a chord X₄₀ of the circle, the chord intersecting the longitudinal central axis Y₁₀ of the wafer boat, each finger of the third set comprising:
an elongated segment (50) that extends from the third vertical rod; and
a contact protuberance (52) disposed on the elongated segment toward a distal end (34) of the finger (30) for contacting and supporting a semiconductor wafer, at least a portion of the contact protuberance being raised with respect to the elongated segment,
wherein the contact protuberances of the first, second, and third sets of fingers are spaced 120° about the wafer boat, **characterized in that** each contact protuberance is rounded by increasing in height from sides of the contact protuberance to an apex that extends along the finger axis, and **in that** each contact protuberance has a longitudinal contact protuberance axis, a length extending along the longitudinal contact protuberance axis, and a width perpendicular to the length, the width of each contact protuberance being 3 mm to 20 mm, the length of each contact protuberance being 10 mm to 50 mm, and the distance from the contact protuberance to a longitudinal central axis of the wafer boat being from 75 mm to 125 mm, for resting the semiconductor wafer on the rounded contact protuberance generally along the longitudinal contact protuberance axis.

2. The wafer boat as set forth in claim 1 wherein the width is 8 mm, the length is 30 mm, and the distance from the contact protuberance to the longitudinal central axis of the wafer boat is 100 mm.

## Patentansprüche

1. Ein Waferboot (10) zum Tragen einer Vielzahl von Halbleiterwafern in einem Ofen, umfassend:
eine erste vertikale Stange (20);
einen ersten Satz (36) von Fingern (30), die sich von der ersten vertikalen Stange entlang einer ersten Fingerachse A₃₆ radial nach innen erstrecken, wobei sich die erste Fingerachse über eine Sehne X₃₆ eines Kreises erstreckt, dessen Mittelpunkt über einer Längsmittelachse Y₁₀ des Waferboots liegt, wobei die Sehne die Längsmittelachse Y₁₀ des Waferboots nicht schneidet, wobei jeder Finger des ersten Satzes umfasst:
ein längliches Segment (50), das sich von der ersten vertikalen Stange erstreckt; und
eine Kontaktvorwölbung (52), die auf dem länglichen Segment in Richtung eines distalen Endes (34) des Fingers (30) angeordnet ist, um einen Halbleiterwafer zu kontaktieren und zu stützen, wobei mindestens ein Teil der Kontaktvorwölbung in Bezug auf das längliche Segment erhöht ist;
eine zweite vertikale Stange (20);
einen zweiten Satz (38) von Fingern (30), die sich von der zweiten vertikalen Stange entlang einer zweiten Fingerachse A₃₈ radial nach innen erstrecken, wobei sich die zweite Fingerachse über eine Sehne X₃₈ des Kreises erstreckt, wobei die Sehne die Längsmittelachse Y₁₀ des Waferboots nicht schneidet, wobei jeder Finger des zweiten Satzes umfasst:
ein längliches Segment (50), das sich von der zweiten vertikalen Stange erstreckt; und
eine Kontaktvorwölbung (52), die auf dem länglichen Segment in Richtung eines distalen Endes (34) des Fingers (30) angeordnet ist, um einen Halbleiterwafer zu kontaktieren und zu stützen, wobei mindestens ein Teil der Kontaktvorwölbung gegenüber dem länglichen Segment erhöht ist;
eine dritte vertikale Stange (18);
einen dritten Satz (40) von Fingern (30), die sich von der dritten vertikalen Stange entlang einer dritten Fingerachse A₄₀ radial nach innen erstrecken, wobei sich die dritte Fingerachse über eine Sehne X₄₀ des Kreises erstreckt, wobei die Sehne die Längsmittelachse Y₁₀ des Waferboots schneidet, wobei jeder Finger des dritten Satzes umfasst:
ein längliches Segment (50), das sich von der dritten vertikalen Stange erstreckt; und
eine Kontaktvorwölbung (52), die auf dem länglichen Segment in Richtung eines distalen Endes (34) des Fingers (30) angeordnet ist, um einen Halbleiterwafer zu kontaktieren und zu stützen, wobei mindestens ein Teil der Kontaktvorwölbung gegenüber dem länglichen Segment erhöht ist,
wobei die Kontaktvorwölbungen des ersten, zweiten und dritten Satzes von Fingern im Abstand von 120° um das Waferboot herum beabstandet sind, **dadurch gekennzeichnet, dass** jede Kontaktvorwölbung abgerundet ist, indem sie von den Seiten der Kontaktvorwölbung zu einer Spitze, die sich entlang der Fingerachse erstreckt, an Höhe zunimmt, und dass jede Kontaktvorwölbung eine Kontaktvorwölbungslängsachse, eine Länge entlang der Kontaktvorwölbungslängsachse, und eine zu dieser Länge senkrechte Breite aufweist, wobei die Breite jeder Kontaktvorwölbung 3 mm bis 20 mm beträgt, die Länge jeder Kontaktvorwölbung 10 mm bis 50 mm beträgt und der Abstand von der Kontaktvorwölbung zu einer Längsmittelachse des Waferboots 75 mm bis 125 mm beträgt, um den Halbleiterwafer im Wesentlichen entlang der Kontaktvorwölbungslängsachse auf dem abgerundeten Kontaktvorsprung aufliegen zu lassen.

2. Das Waferboot gemäß Anspruch 1, wobei die Breite 8 mm beträgt, die Länge 30 mm beträgt und der Abstand von der Kontaktvorwölbung zur Längsmittelachse des Waferboots 100 mm beträgt.

## Revendications

1. Nacelle porte-plaquettes (10) destinée à supporter une pluralité de plaquettes semi-conductrices dans un four, comportant :
une première tige verticale (20),
un premier ensemble (36) de doigts (30) qui s'étendent radialement vers l'intérieur à partir de la première tige verticale le long d'un premier axe de doigts A₃₆, le premier axe de doigts s'étendant sur une corde X₃₆ d'un cercle centré autour d'un axe central longitudinal Y₁₀ de la nacelle porte-plaquettes, la corde ne croisant pas l'axe central longitudinal Y₁₀ de la nacelle porte-plaquettes, chaque doigt du premier ensemble comportant :
un segment allongé (50) qui s'étend à partir de la première tige verticale, et
une protubérance de contact (52) disposée sur le segment allongé vers une extrémité distale (34) du doigt (30) pour entrer en contact avec une plaquette semi-conductrice et soutenir celle-ci, au moins une partie de la protubérance de contact étant surélevée par rapport au segment allongé,
une deuxième tige verticale (20),
un deuxième ensemble (38) de doigts (30) qui s'étendent radialement vers l'intérieur à partir de la deuxième tige verticale le long d'un deuxième axe de doigts A₃₈, le deuxième axe de doigts s'étendant sur une corde X₃₈ du cercle, la corde ne croisant pas l'axe central longitudinal Y₁₀ de la nacelle porte-plaquettes, chaque doigt du deuxième ensemble comportant :
un segment allongé (50) qui s'étend à partir de la deuxième tige verticale, et
une protubérance de contact (52) disposée sur le segment allongé vers une extrémité distale (34) du doigt (30) pour entrer en contact avec une plaquette semi-conductrice et soutenir celle-ci, au moins une partie de la protubérance de contact étant surélevée par rapport au segment allongé,
une troisième tige verticale (18),
un troisième ensemble (40) de doigts (30) qui s'étendent radialement vers l'intérieur à partir de la troisième tige verticale le long d'un troisième axe de doigts A₄₀, le troisième axe de doigts s'étendant sur une corde X₄₀ du cercle, la corde croisant l'axe central longitudinal Y₁₀ de la nacelle porte-plaquettes, chaque doigt du troisième ensemble comportant :
un segment allongé (50) qui s'étend à partir de la troisième tige verticale, et
une protubérance de contact (52) disposée sur le segment allongé vers une extrémité distale (34) du doigt (30) pour entrer en contact avec une plaquette de semiconducteur et soutenir celle-ci, au moins une partie de la protubérance de contact étant surélevée par rapport au segment allongé,
dans lequel les protubérances de contact des premier, deuxième et troisième ensembles de doigts sont espacées de 120° autour de la nacelle porte-plaquettes, **caractérisée en ce que** chaque protubérance de contact est arrondie en augmentant en hauteur à partir des côtés de la protubérance de contact jusqu'à un sommet qui s'étend le long de l'axe de doigts, et **en ce que** chaque protubérance de contact a un axe de protubérance de contact longitudinal, une longueur s'étendant le long de l'axe de protubérance de contact longitudinal et une largeur étant perpendiculaire à la longueur, la largeur de chaque protubérance de contact étant de 3 mm à 20 mm, la longueur de chaque protubérance de contact étant de 10 mm à 50 mm, et la distance de la protubérance de contact à un axe central longitudinal de la nacelle porte-plaquettes étant de 75 mm à 125 mm, pour faire reposer la plaquette semi-conductrice sur la protubérance de contact arrondie généralement le long de l'axe de protubérance de contact longitudinal.

2. Nacelle porte-plaquettes selon la revendication 1, dans laquelle la largeur est de 8 mm, la longueur est de 30 mm et la distance de la protubérance de contact à l'axe central longitudinal de la nacelle porte-plaquettes est de 100 mm.
